# EUROPEAN PATENT APPLICATION

(11) **EP 4 708 607 A1**
(43) Date of publication of application: **11.03.2026**
(21) Application number: 25200795.0
(22) Date of filing: 08.09.2025
(51) Int. Cl.: H02J 1/102, H02J 1/14, H02J 3/28, H02J 7/34, H02J 7/82, H02J 15/50

(54) **FUEL CELL SYSTEM ARCHITECTURE FOR ARTIFICIAL INTELLIGENCE DATA CENTERS**

(30) Priority: 09.09.2024 US 202463692623 P
(71) Applicant: Bloom Energy Corporation, San Jose, CA 95134 (US)
(72) Inventor: KUMAR ROY, Rakesh, San Jose, CA 95134 (US); VISHNUVARJULA, Anilkumar, San Jose, CA 95134 (US); DIXIT, PavanKumar, San Jose, CA 95134 (US); NARAYANASAMY, Saravana, San Jose, CA 95134 (US); GURUNATHAN, Ranganathan, San Jose, CA 95134 (US); BAKER, Beau, San Jose, CA 95134 (US); BOMMIREDDY, Vignan Reddy, San Jose, CA 95134 (US); PMSVVSV, Prasad, San Jose, CA 95134 (US)
(74) Representative: Hoffmann Eitle

(57) **Abstract**

The present disclosure is directed to a system that employs fuel cell-based power generation for various loads, such as data centers for artificial intelligence (AI) model training. The system utilizes various modules, such as different types of energy storage devices, to supplement power output by the fuel cells, as well as store any excess power generated by the fuel cell systems. As a result, swings in the power output by the fuel cells are minimized and the life of the fuel cells may be extended.

## Description

### BACKGROUND

### Technical Field

The present disclosure is directed to system architectures and power control methods for fuel cell systems.

### Description of the Related Art

Fuel cells, such as solid oxide fuel cells (SOFC), are energy conversion devices that can produce electricity and heat directly from hydrogen and hydrocarbon gases. Fuel cell systems are capable of generating power continuously without interruption. Fuel cell systems are highly efficient compared to conventional power generation devices. For instance, in a diesel generator, diesel fuel and compressed air are ignited, converting the chemical energy of the fuel to thermal energy; thermal energy is then transformed to mechanical energy (e.g., using heat to drive a turbine); and mechanical energy is finally converted to electrical energy. In contrast, fuel cell systems bypass the conversion of mechanical energy into electrical energy. Instead, fuel cells generate electricity and heat via an electrochemical reaction, contributing to clean baseload power and serving as a backup solution.

Due to these advantages, fuel cell systems are desirable as a primary power source for various applications seeking reliable, sustainable, clean energy. As such, fuel cell systems can be used to power decentralized data centers that perform large, processing intensive tasks, such as data centers that support artificial intelligence (AI) training processes.

### BRIEF SUMMARY

The present disclosure is directed to system architectures and control methods that employ fuel cells, such as SOFCs, as a primary energy source.

The system architectures and control methods utilize various supporting modules and technologies that place power load demands on the fuel cells and minimize power ripples from the load. The architectures and control methods are particularly useful for AI data center loads due to their highly variable loads. In cases where there is excess power on the power bus due to, for example, the load decreasing, the excess power is transferred to energy storage devices, a resistive load bank, an external grid, or a combination thereof. Conversely, in cases where there is insufficient power on the power bus due to, for example, the load increasing, additional power is provided to the power bus from one or more energy storage devices.

A hybrid energy storage solution is employed to further improve performance. For example, different types of energy storage devices, including high density energy storage devices and a low density energy storage devices, are used to store power from the power bus and provide power to the power bus depending on the situation. The high density energy storage devices are able to store large amounts of power for long periods of time. In contrast, the low density energy storage devices are able to store a lower amounts of power for a shorter period of time, but have fast charging and discharging times.

As a result of the various supporting modules and technologies, swings in power output by the fuel cell systems are minimized and the operational life of the fuel cells in the fuel cell systems are extended.

### BRIEF DESCRIPTION OF THE SEVERAL VIEWS OF THE DRAWINGS

In the drawings, identical reference numbers identify similar features or elements. The size and relative positions of features in the drawings are not necessarily drawn to scale.
Figure 1 shows a power generation, storage and distribution system according to an embodiment disclosed herein.
Figure 2 shows an exemplary fuel cell power system according to an embodiment disclosed herein.
Figure 3 shows a system and method of managing charging of a high density energy storage device according to an embodiment disclosed herein.
Figure 4 shows a system and method of managing charging of a low density energy storage device according to an embodiment disclosed herein.
Figure 5 shows a system and method of managing discharging of a low density energy storage device according to an embodiment disclosed herein.
Figure 6 shows signals for a load, a high density energy storage device, and fuel cell power system according to an embodiment disclosed herein.
Figure 7 shows a system and method of managing discharging of energy storage devices according to an embodiment disclosed herein.
Figure 8 shows signals for a high density energy storage device according to an embodiment disclosed herein.
Figure 9 shows signals for three high density energy storage devices according to an embodiment disclosed herein.
Figure 10 shows a system and method of managing discharging of a direct current (DC) bus to a resistive load bank according to an embodiment disclosed herein.
Figure 11 shows a system and method of managing discharging of a direct current (DC) bus to an external grid according to an embodiment disclosed herein.

### DETAILED DESCRIPTION

In the following description, certain specific details are set forth to provide a thorough understanding of various aspects of the disclosed subject matter. However, the disclosed subject matter may be practiced without these specific details. In some instances, structures, functions, and methods of manufacturing of electronic devices, electronic components, and power systems have not been described in detail to avoid obscuring the descriptions of other aspects of the present disclosure.

Unless the context requires otherwise, throughout the specification and claims that follow, the word "comprise" and variations thereof, such as "comprises" and "comprising," are to be construed in an open, inclusive sense, that is, as "including, but not limited to."

Reference throughout the specification to "one embodiment" or "an embodiment" means that a particular feature, structure, or characteristic described in connection with the embodiment is included in at least one embodiment. Thus, the appearance of the phrases "in one embodiment" or "in an embodiment" in various places throughout the specification are not necessarily all referring to the same aspect. Furthermore, the particular features, structures, or characteristics may be combined in any suitable manner in one or more aspects of the present disclosure.

As discussed above, fuel cell systems can provide efficient, clean, and continuous power, and are a desirable choice for various applications. However, power consumption profiles of many applications present challenges for fuel cell systems to meet power output requirements or specifications over an extended period of time.

Data centers running AI processes are challenging for fuel cell systems due to their highly variable loads. Data centers running AI processes have a nature of creating frequent power ripples on fuel cell systems, which in turn disturbs the stability of power generation by the fuel cell systems. For example, when a load and power consumption of the data center suddenly decreases, the fuel cell system has a surplus of generated power on the power bus. Conversely, when the load and power consumption of the data center running AI processes suddenly increases, there is a power deficiency on the power bus and the fuel cell system may not be able to immediately meet the increased power demand. It takes time for the fuel cell system to ramp up its power output level. In addition, frequent and fast changing loads can degrade and shorten the operational life of fuel cells present in fuel cell systems.

Accordingly, it is desirable for fuel cell systems to include power buffering solutions that consume surplus power generated by the fuel cell systems in response to the load of the data center suddenly decreasing, and power discharging solutions that provide power to the data center quickly in response to the load of the data center suddenly increasing.

The present disclosure is directed to system architectures and control methods that employ fuel cells, such as SOFCs, as the primary energy source. The system architectures and control methods include various supporting modules and technologies that provide high quality and reliable electricity and minimize the impact of power ripples from the load.

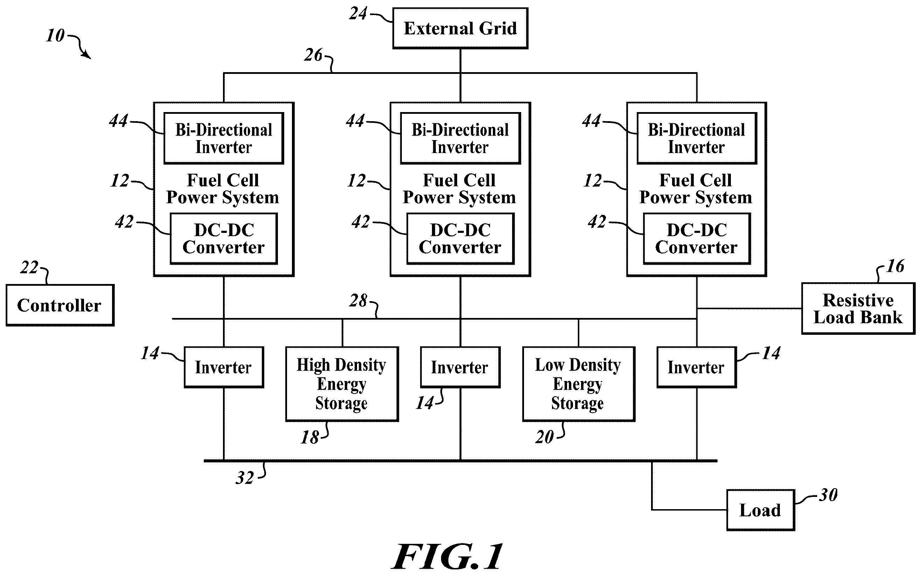

Figure 1 shows a power generation, storage and distribution system 10 according to an embodiment disclosed herein. The system 10 provides a fuel cell-based microgrid that caters to processes with highly variable power consumption levels.

The system 10 includes fuel cell power systems 12, inverters 14, a resistive load bank 16, one or more high density energy storage devices 18, one or more low density energy storage devices 20, and a controller 22. The fuel cell power systems 12 are electrically coupled to each other and to an external grid 24 by an external power bus 26. The fuel cell power systems 12, the inverters 14, the resistive load bank 16, one or more high density energy storage devices 18, and one or more low density energy storage devices 20 are electrically coupled to each other by a direct current (DC) power bus 28. The inverters 14 are electrically coupled to each other and to a load 30 by an alternating current (AC) power bus 32. The controller 22 is communicatively coupled to the various components of the system 10, such as the fuel cell power systems 12, the inverters 14, the resistive load bank 16, the high density energy storage devices 18, the low density energy storage devices 20, and the external grid 24.

Although three fuel cell power systems 12 and three corresponding inverters 14 are shown in Figure 1, the system 10 may include any number of fuel cell power systems 12 and corresponding inverters 14, depending on the application. One or more fuel cell power systems 12 may be operational while other fuel cell power systems 12 are being serviced in system 10.

Each of the fuel cell power systems 12 includes one or more fuel cell power modules that act as the primary power source for loads connected to the system 10 (*e.g.,* the load 30 connected to the AC bus 32). The fuel cell power systems 12 operate in parallel on the DC bus 28, and output power signals to the DC bus 28.

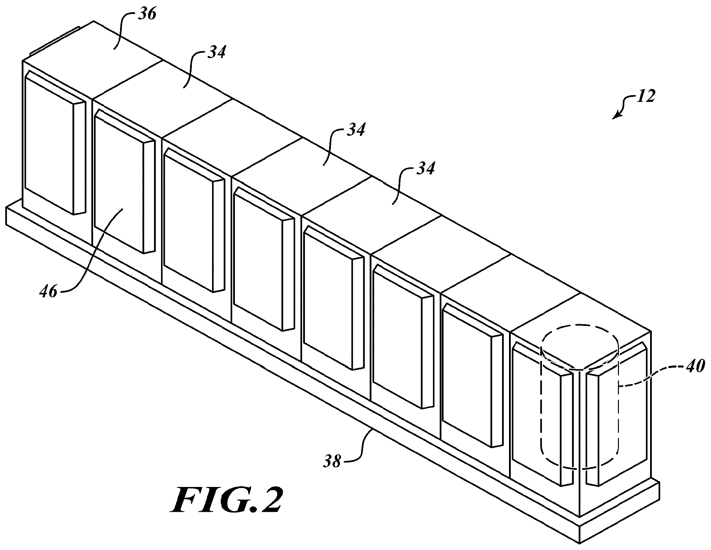

Figure 2 shows an exemplary fuel cell power system 12 according to an embodiment disclosed herein. In this example, the fuel cell power system 12 is a modular fuel cell power system that provides flexible system installation and operation. Modules allow scaling of installed generating capacity, reliable generation of power, flexibility of fuel processing, and flexibility of power output voltages and frequencies. This design also provides an easy means of scale-up to meet specific requirements of customer installations.

The fuel cell power system 12 includes one or more fuel cell power modules 34 and one or more power conditioning (*i.e.,* electrical output) modules 36.

In Figure 2, the exemplary fuel cell power system 12 includes a row of seven fuel cell power modules 34 and one power conditioning module 36 disposed on a pad 38. However, the fuel cell power system 12 may include any number of fuel cell power modules and power conditioning modules and any number of rows of modules. For example, the fuel cell power system 12 may include two rows of fuel cell power modules 34 arranged back to back/end to end. Additionally, the fuel cell power system 12 may include multiple levels of fuel cell power modules 34 in a power tower arrangement.

Each of the fuel cell power modules 34 is configured to house one or more hot boxes 40. Each hot box 40 contains one or more stacks or columns of fuel cells, such as one or more stacks or columns of SOFCs comprised of fuel cells (anode, cathode, and electrolyte) separated by conductive interconnect plates.

The fuel cell stacks may include externally and/or internally manifolded stacks. For example, the stacks may be internally manifolded for fuel and air with fuel and air risers extending through openings in the fuel cell layers and/or in the interconnect plates between the fuel cells. Alternatively, the fuel cell stacks may be internally manifolded for fuel and externally manifolded for air, where only the fuel inlet and exhaust risers extend through openings in the fuel cell layers and/or in the interconnect plates between the fuel cells.

The fuel cells may have a cross flow (where oxidant and fuel flow roughly perpendicular to each other on opposite sides of the fuel cells), counter flow parallel (where oxidant and fuel flow roughly parallel to each other but in opposite directions on opposite sides of the fuel cells), or co-flow parallel (where air and fuel flow roughly parallel to each other in the same direction on opposite sides of the fuel cells) configuration.

The power conditioning module 36 may include components for converting the fuel cell stack generated DC power (*e.g*., DC/DC and DC/AC converters), electrical connectors for AC power output to a grid or AC load, circuits for managing electrical transients, and a system controller (*e.g.,* a computer or dedicated control logic device or circuit). The power conditioning module 36 may be designed to convert DC power from the fuel cell modules to different AC voltages and frequencies. Designs for 208V, 60Hz; 480V, 60Hz; 415V, 50Hz and other common voltages and frequencies may be provided.

In one embodiment, as shown in Figure 1, the power conditioning module 36 includes a DC/DC converter 42 that converts the fuel cell stack generated DC power to a determined DC power used by the DC bus 28, and outputs the determined DC power to the DC bus 28. The power conditioning module 36 also includes a bi-directional inverter 44 to convert power between the external grid 24 and the fuel cell power system 12. For example, a DC to AC converter of the bi-directional inverter 44 may be used to convert DC generated by the fuel cell power system 12 to AC to be used by the external grid 24. An AC to DC converter of the bi-directional inverter 44 may be used convert AC provided by the external grid 24 to DC to be used by the fuel cell power systems 12.

The linear array of fuel cell power modules 34 is readily scaled. For example, more or fewer fuel cell power modules 34 may be provided depending on the power needs of the building or other facility serviced by the fuel cell power system 12. The fuel cell power modules 34 and input/output modules may also be provided in other ratios.

The fuel cell power system 12 is configured in a way to ease servicing of the components of the fuel cell power system 12. For example, the fuel cell power system 12 may include access doors 46. All of the routinely or highly serviced components, such as the consumable components, may also be placed in a single module to reduce the amount of time required for service operations. As another example, when one fuel cell power module 34 is taken offline (*i.e.,* no power is generated by the stacks in the hot box 40 in the offline fuel cell power module 34), the remaining fuel cell power modules 34 and the power conditioning module 36 are not taken offline. Furthermore, the fuel cell power system 12 may contain more than one of each type of module 34, 36. When at least one module of a particular type is taken offline, the remaining modules of the same type are not taken offline. Thus, in a system including a plurality of modules, each of the modules 34 or 36 may be electrically disconnected, removed from the fuel cell power system 12 and/or serviced or repaired without stopping an operation of the other modules in the system, allowing the fuel cell power system 12 to continue to generate electricity. The entire fuel cell power system 12 does not have to be shut down if one stack of fuel cells in one hot box 40 malfunctions or is taken offline for servicing. Moreover, the fuel cell system 12 can include redundant modules that can be brought on-line when other modules are being serviced or replaced.

Returning to Figure 1, the external grid 24 is electrically coupled to the fuel cell power systems 12. The external grid 24 provides power to the fuel cell power systems 12 in order to start up and initiate power generation by the fuel cell power systems 12. In addition, as will be discussed in further detail below, it is also possible to export surplus power on the DC bus 28 to the external grid 24. The external grid 24 may be any type of electrical grid.

The inverters 14 are electrically coupled between the DC bus 28 and the AC bus 32. The inverters 14 convert DC power from the DC bus 28 to AC power and provide the converted AC power to the AC bus 32. The AC bus 32 in turn powers the load 30.

The load 30 is an AC load that is powered by the AC bus 32. The load 30 connected to the AC bus 32 is mainly powered by the system 10, more specifically, by the fuel cell power systems 12. Stated differently, the load 30 receives the majority of its power from the fuel cell power systems 12. In one embodiment, the load 30 is a data center that performs processes, such as AI training processes (e.g., processing data using deep neural networks, linear regression, logistic regression, decision trees, random forest techniques, supervised learning, unsupervised learning, reinforcement learning, transfer learning, semi-supervised learning, generative models, etc.). As discussed above, power consumption profiles of data centers running AI processes are particularly challenging due to their highly variable loads, and, thus, would greatly benefit from the system 10. However, the load 30 may be any type of load that has variable power consumption besides data centers running AI-related processes.

In order to reduce power swings in the output of the fuel cell power systems 12 and minimize degradation of the fuel cells contained in the fuel cell power systems 12, the system 10 includes power buffering solutions to consume surplus power of the fuel cell power systems 12 and power discharging solutions to supplement the output power of the fuel cell power systems 12.

The resistive load bank 16 is electrically coupled to the DC bus 28 and includes one or more resistive elements. The resistive load bank 16 is a controllable resistive load that dissipates excess power on the DC bus 28. When the load 30 suddenly decreases, surplus power generated by the fuel cell power systems 12 and present on the DC bus 28 is dissipated through the resistive load bank 16. Conversely, when the load 30 suddenly increases, there will be little to no surplus power generated by the fuel cell power systems 12 on the DC bus 28. Thus, little to no power is dissipated through the resistive load bank 16. Any power originally dissipated through the resistive load bank 16 is instead diverted to the load 30 when the demand suddenly increases. The amount of power the resistive load bank 16 consumes depends on the excess power available from the fuel cell power systems 12 after catering to the load 30, as well as the high density energy storage devices 18 and the low density energy storage devices 20 at any instant.

In one embodiment, the resistive load bank 16 utilizes pulse width modulation to control the amount of power dissipated through the resistive load bank 16. In response to the power consumption of the load 30 decreasing, the duty cycle of the resistive load bank 16 is increased (e.g., the duration of cycles in which power is transferred from the DC bus 28 to the resistive load bank 16 is increased). As a result, the fuel cell power systems 12 may maintain their current power output and will see very little to no disturbance on the DC bus 28. Conversely, in response to the power consumption of the load 30 increasing, the duty cycle of the resistive load bank 16 is decreased (e.g., the duration of cycles in which power is transferred from the DC bus 28 to the resistive load bank 16 is decreased).

In one embodiment, the controller 22 sets the amount of power dissipated through the resistive load bank 16 based on the current total amount of power on the DC bus 28. For example, the controller increases the amount of power dissipated through the resistive load bank 16 in response to the total amount of power on the DC bus 28 being equal to or greater than a determined threshold value, and decreases the amount of power dissipated through the resistive load bank 16 in response to the total amount of power on the DC bus 28 being less than the determined threshold value. In this embodiment, control of the resistive load bank 16 does not depend on any communication or information about the load 30.

In another embodiment, the controller 22 sets the amount of power dissipated through the resistive load bank 16 based on the current load (e.g., current power consumption) of the load 30. For example, the controller 22 increases the amount of power dissipated through the resistive load bank 16 in response to the load 30 being equal to or lower than a determined threshold value, and decreases the amount of power dissipated through the resistive load bank 16 in response to the load 30 being greater than the determined threshold value.

In some cases, dissipating surplus power through the resistive load bank 16 is inefficient as generated power is being wasted. Further, the dissipation may create unwanted heat in the system 10. One or more high density energy storage devices 18 and one or more low density energy storage devices 20 provide additional options to the resistive load bank 16.

The high density energy storage devices 18 and the low density energy storage devices 20 are energy or power storage systems configured to output power signals to the DC bus 28 and receive power signals from the DC bus 28. The high density energy storage devices 18 and the low density energy storage devices 20 are used to reduce the magnitude of power changes that the fuel cell power systems 12 would otherwise experience in the absence of those devices. The high density energy storage devices 18 and the low density energy storage devices 20 act as power buffers to store excess power on the DC bus 28 (e.g., when power consumption of the load 30 is lower than the total power output of the fuel cell power systems 12). In addition, the high density energy storage devices18 and the low density energy storage devices 20 provide power to the DC bus 28 when there is a shortage of power on the DC bus 28 (*e.g*., when power consumption of the load 30 is greater than the total power output of the fuel cell power systems 12).

Although one high density energy storage device 18 and one low density energy storage device 20 are shown in Figure 1, the system 10 may include any number of energy storages. Various operation methods for the high density energy storage devices 18 and the low density energy storage devices 20 will be discussed in further detail below. While the discussion below provides examples of systems with one high density energy storage device and one low density energy storage device, such systems may include one or more of each energy storage device.

The high density energy storage devices 18 and the low density energy storage devices 20 are different types of storage systems that provide a hybrid storage solution in order to achieve optimum performance of the system 10.

The high density energy storage device 18 has a high energy density (e.g., higher than the low density energy storage device 20) such that it can store large amounts of power for longer periods of time. For example, the high density energy storage device 18 is capable of storing a first total amount of power (a first power capacity) that is greater than a second total amount of power which the low density energy storage device 20 is capable of storing (a second power capacity). However, due to its high energy density, the high density energy storage devices 18 has slow charging and discharging times. In one embodiment, the high density energy storage device 18 may include one or more electrochemical cells, such as lithium ion cells. However, the present disclosure is not limited to any particular type of electrochemical cell. In another embodiment, the high density energy storage device 18 may include any rechargeable wet cell battery, rechargeable dry cell battery, and/or any rechargeable solid state battery. The term "battery" may be used interchangeably herein to refer to a battery pack, which may include any number of batteries, a battery, which may include any number of battery cells, and/or a battery cell of a battery.

In contrast to the high density energy storage device 18, the low density energy storage device 20 has low energy density (*e.g*., lower than the high density energy storage device 18) such that it can store a low amount of power for a shorter period of time. However, the low density energy storage device 20 is capable of fast charging and discharging times. For example, the low density energy storage device 20 is capable of performing a charge or discharge in a first total amount of time that is faster than a second total amount of time which the high density energy storage device 18 is capable of performing. In one embodiment, the low density energy storage device 20 comprises one or more ultracapacitors or a supercapacitors.

By utilizing energy storage devices with different characteristics, one of the high density energy storage devices 18 and/or one of the low density energy storage devices 20 is selected for performing a charging or discharging function depending on the power available on the DC bus 28 and the current power consumption of the load 30.

In one embodiment, the high density energy storage device 18 is used to supplement the power generated by the fuel cell power systems 12 and store excess power generated by the fuel cell power systems 12. Similarly, the low density energy storage device 20 is also used to supplement the power generated by the fuel cell power systems 12 and store excess power generated by the fuel cell power systems 12. However, the low density energy storage device 20 is selected for cases in which the amount of power to supplement the power generated by the fuel cell power systems 12 is small (*e.g.*, below a determined threshold value) and faster charging and discharging times are desired.

The controller 22 is communicatively coupled to and controls the various functions of the fuel cell power systems 12, the inverters 14, the resistive load bank 16, the high density energy storage device 18, and the low density energy storage device 20. The controller 22 can also be communicatively coupled to the grid 24. The controller 22 manages the power balance between different generation modules (*e.g*., the fuel cell power systems 12, the high density energy storage device 18, and the low density energy storage device 20), storage modules (*e.g.*, the resistive load bank 16, the high density energy storage device 18, and the low density energy storage device 20), and loads (*e.g.,* the load 30) of the system 10 in real time.

The controller 22 controls the fuel cell power systems 12 to provide power in parallel. In one embodiment, the controller 22 utilizes a Droop power control method for sharing the load 30 between the fuel cell power systems 12. For example, the controller 22 adjusts the power output of each of the fuel cell power systems 12 in parallel based on a deviation of the power output frequency from a reference frequency.

The controller 22 may be any type of processor, signal processor, or controller that is able to process data; and may include one or more processors. For example, the controller 22 may comprise an industrial personal computer (PC), a programmable logic controller (PLC), microcontroller, digital signal processor (DSP), field programmable gate arrays (FPGAs), or other similar technologies.

The controller 22 continuously measures the current state of charge (SOC) (*e.g.,* current stored charge) of the high density energy storage device 18 and the low density energy storage device 20; the power output from the fuel cell power systems 12, the high density energy storage device 18, and the low density energy storage device 20 to the DC bus 28; the power input to the resistive load bank 16, the high density energy storage device 18, and the low density energy storage device 20 from the DC bus 28; and the power input to the load 30 from the AC bus 32. The controller 22 manages power flows to or from (*e.g*., sets power levels input to or output from) each of the fuel cell power systems 12, the resistive load bank 16, the high density energy storage device 18, the low density energy storage device 20, and the load 30, based on the measurements by the controller 22.

For the high density energy storage device 18, the controller 22 (or the high density energy storage device 18 itself) continuously monitors the power on the DC bus 28, and starts charging the high density energy storage device 18 in case the current power on the DC bus 28 (P_DCBUS) is greater than a DC bus threshold value (CH_TH1). The controller 22 also monitors the total output power from the DC bus 28 to any electrical components connected to the DC bus 28 (*e.g.,* the fuel cell power systems 12, the inverters 14, the resistive load bank 16, the high density energy storage device 18, and the low density energy storage device 20) (P_CH1, P_CH2 ... P_CHN) to ensure that the total output power does not exceed a max power rating of the system 10 (MAXCHSYS_TH).

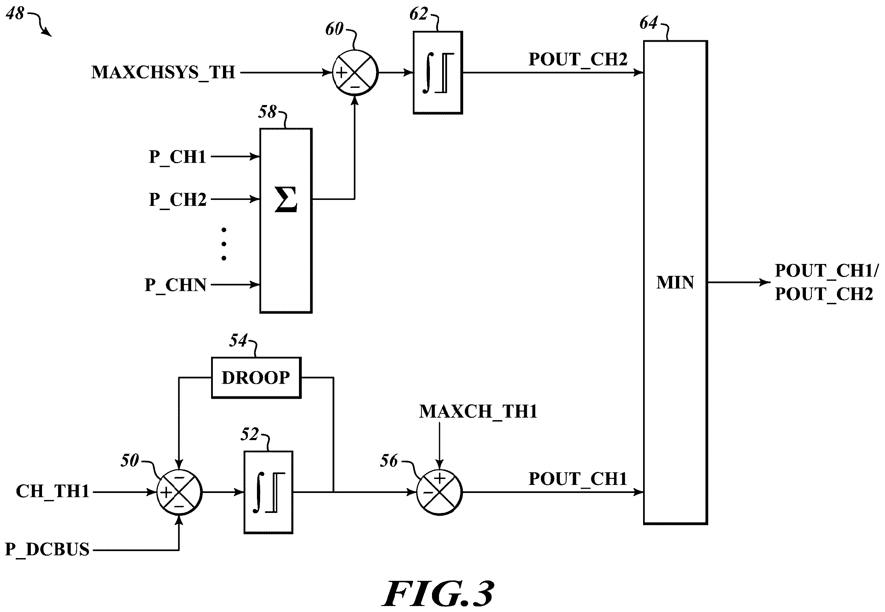

Figure 3 shows a system and method 48 of managing charging of the high density energy storage device 18 according to an embodiment disclosed herein. In Figure 3, the controller 22 utilizes proportional integration control to charge the high density energy storage device 18, and Droop power control for sharing the load 30 between the fuel cell power systems 12 in parallel.

In block 50, the controller 22 (or the high density energy storage device 18) determines a difference between (1) the DC bus threshold value (CH_TH1) and (2) the current power level on the DC bus 28 (P_DCBUS) and the droop (*e*.*g*., voltage droop), if any, applied to the fuel cell power systems 12 (DROOP) (CH_TH1 - P_DCBUS - DROOP).

In block 52, the controller 22 (or the high density energy storage device 18) determines an integral value of the difference determined in block 50 over a determined amount of time. The integral value represents the accumulation of the difference over the determined amount of time.

In block 54, the controller 22 (or the high density energy storage device 18) adjusts the value of the droop applied to the fuel cell power systems 12 (DROOP) based on the integral value determined in block 52. The adjusted droop is then used in a subsequent execution of block 50.

In block 56, the controller 22 (or the high density energy storage device 18) determines a difference between (1) a max charging rating of the high density energy storage device 18 (MAXCH_TH1) and (2) the integral value determined in block 52. The difference determined in block 56 is a first candidate output power for charging the high density energy storage device 18 (POUT_CH1).

In block 58, the controller 22 determines the sum or total of the power output from the DC bus 28 to one or more of the electrical components connected to the DC bus 28 (*e.g.,* the fuel cell power systems 12, the inverters 14, the resistive load bank 16, the high density energy storage 18, and the low density energy storage 20) (P_CH1, P_CH2 ... P_CHN).

In block 60, the controller 22 determines a difference between (1) the max power rating of the system 10 (MAXCHSYS_TH) and (2) the sum determined in block 58.

In block 62, the controller 22 determines an integral value of the difference determined in block 60 over a determined amount of time. The integral value represents the accumulation of the difference over the determined amount of time. The integral value determined in block 62 is a second candidate output power for charging the high density energy storage device 18 (P_CH2).

In block 64, the controller 22 selects the minimum of (1) the first candidate output power for charging the high density energy storage device 18 (POUT_CH1) determined in block 56 and (2) the second candidate output power for charging the high density energy storage device 18 (POUT_CH2) determined in block 62. Stated differently, the controller 22 selects the output power out of the first candidate output power (POUT_CH1) and the second candidate output power (POUT_CH2), that has the smallest value. The selected output power is then output from the DC bus 28 to the high density energy storage device 18 in order to charge the high density energy storage device 18.

Similarly, for the low density energy storage device 20, the controller 22 (or the low density energy storage device 20 itself) continuously monitors the power on the DC bus 28, and starts charging the low density energy storage device 20 in case the current power on the DC bus 28 (P_DCBUS) is equal to or greater than a DC bus threshold value (CH_TH2).

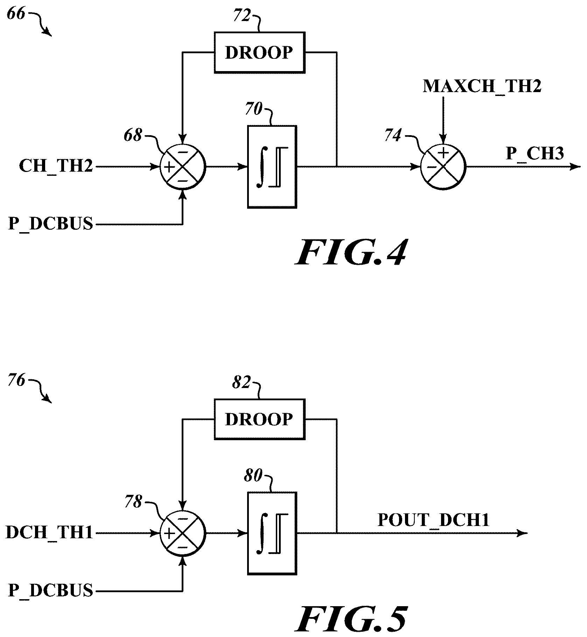

Figure 4 shows a system and method 66 of managing charging of the low density energy storage device 20 according to an embodiment disclosed herein. In Figure 4, the controller 22 utilizes proportional integration control to charge the low density energy storage device 20, and Droop power control for sharing the load 30 between the fuel cell power systems 12 in parallel.

In block 68, the controller 22 (or the low density energy storage device 20) determines a difference between (1) the DC bus threshold value (CH_TH2) and (2) the current power level on the DC bus 28 (P_DCBUS) and the droop (*e*.*g*., voltage droop), if any, applied to the fuel cell power systems 12 (DROOP) (CH_TH2 - P_DCBUS - DROOP). In one embodiment, the DC bus threshold value (CH_TH2) in block 68 is smaller than the DC bus threshold value (CH_TH1) in block 50, due to the low density energy storage device 20 having lower storage capacity than the high density energy storage device 18.

In block 70, the controller 22 (or the low density energy storage device 20) determines an integral value of the difference determined in block 68 over a determined amount of time. The integral value represents the accumulation of the difference over the determined amount of time.

In block 72, the controller 22 (or the low density energy storage device 20) adjusts the value of the droop applied to the fuel cell power systems 12 (DROOP) based on the integral value determined in block 70. The adjusted droop is then used in a subsequent execution of block 68.

In block 74, the controller 22 (or the low density energy storage device 20) determines a difference between (1) a max charging rating of the low density energy storage device 20 (MAXCH_TH2) and (2) the integral value determined in block 70. The difference determined in block 74 is set as the output power for charging the low density energy storage device 20 (P_CH3), and output from the DC bus 28 to the low density energy storage device 20. In one embodiment, the max charging rating (MAXCH_TH2) in block 74 is smaller than the max charging rating (MAXCH_TH2) in block 56, due to the low density energy storage device 20 having lower storage capacity than the high density energy storage device 18.

In addition, the controller 22 (or the low density energy storage device 20 itself) continuously monitors the power on the DC bus 28, and starts discharging the low density energy storage device 20 to the DC bus 28 in case the current power on the DC bus 28 (P_DCBUS) is less than a DC bus threshold value (DCH_TH1).

Figure 5 shows a system and method 76 of managing discharging of the low density energy storage device 20 according to an embodiment disclosed herein. In Figure 5, the controller 22 utilizes proportional integration control to discharge the low density energy storage 20, and Droop power control for sharing the load 30 between the fuel cell power systems 12 in parallel.

In block 78, the controller 22 (or the low density energy storage device 20) determines a difference between (1) the DC bus threshold value (DCH_TH1) and (2) the current power level on the DC bus 28 (P_DCBUS) and the droop (*e*.*g*., voltage droop), if any, applied to the fuel cell power systems 12 (DROOP) (DCH_TH1 - P_DCBUS - DROOP). In one embodiment, the DC bus threshold value (DCH_TH1) in block 78 is equal to the DC bus threshold value (CH_TH2) in block 68.

In block 80, the controller 22 (or the low density energy storage device 20) determines an integral value of the difference determined in block 78 over a determined amount of time. The integral value represents the accumulation of the difference over the determined amount of time.

In block 82, the controller 22 (or the low density energy storage device 20) adjusts the value of the droop applied to the fuel cell power systems 12 (DROOP) based on the integral value determined in block 80. The adjusted droop is then used in a subsequent execution of block 78.

The integral value determined in block 80 is set as the output power for discharging the low density energy storage device 20 (POUT_DCH1), and output from the low density energy storage device 20 to the DC bus 28. As a result, the power output from the low density energy storage device 20 supplements the power output from the fuel cell power systems 12, and may be used to meet an increase in demand from the load 30.

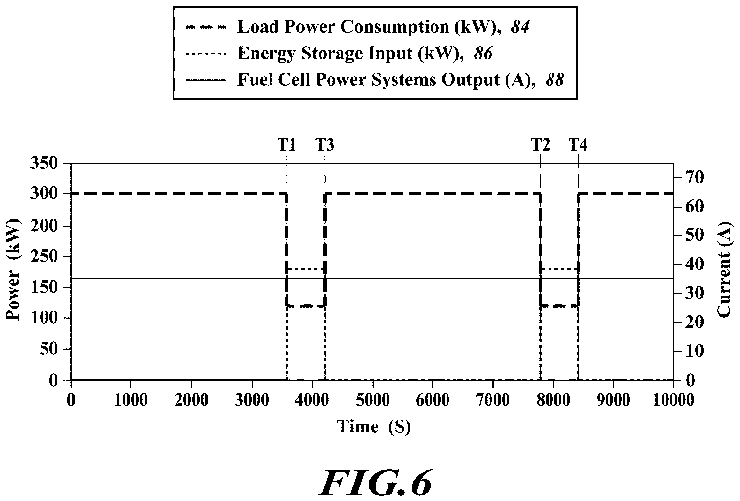

By using the high density energy storage device 18 and the low density energy storage device 20 as power buffers to store excess power on the DC bus 28, fluctuations in the power output of the fuel cell power system 12 may be minimized. For example, Figure 6 shows signals for the load 30, the high density energy storage device 18, and the fuel cell power systems 12 according to an embodiment disclosed herein.

A signal 84 indicates the power consumption of the load 30, a signal 86 indicates the power input to the high density energy storage device 18, and a signal 88 indicates the total electrical current output from the fuel cell power systems 12. The left vertical axis is an amplitude axis in kilowatts, the right vertical axis is an amplitude axis in amps, and the horizontal axis is a time axis in seconds. Although the signal 86 is for the high density energy storage device 18, the power input to the low density energy storage device 20 or another type of energy storage device will have similar characteristics.

As the signal 84, which is the power consumption of the load 30, decreases (*e.g*., starting at times T1 and T2), the controller 22 increases the power input to the high density energy storage device 18. As a result, the signal 86, which indicates the power input to the high density energy storage device 18, concurrently increases (*e.g*., starting at times T1 and T2).

Conversely, as the signal 84, which is the power consumption of the load 30, increases (*e.g*., starting at times T3 and T4), the controller 22 decreases the power input to the high density energy storage device 18. As a result, the signal 86, which indicates the power input to the high density energy storage device 18, concurrently decreases (*e*.*g*., starting at times T3 and T4).

As a result of the power input to the high density energy storage device 18 increasing or decreasing in response to changes in the power consumption of the load 30, the signal 88, which indicates the electrical current output from the fuel cell power systems 12, may remain relatively stable and the current drawn from the fuel cell power systems 12 remains undisturbed. Accordingly, the number charging and discharge cycles encountered by the fuel cell power systems 12 is reduced and the useful lives of the fuel cells in the fuel cell power systems 12 is extended.

As the high density energy storage device 18 and/or the low density energy storage device 20 are charged each time there is a surplus of power on the DC bus 28 *(e.g.,* each time power consumption of the load 30 decreases), the state of charge (SOC) *(e.g.,* current stored charge) of each of the high density energy storage device 18 and/or the low density energy storage device 20 is repeatedly increased. Eventually, the high density energy storage device 18 and the low density energy storage device 20 will reach their maximum SOC *(e.g.,* 100%). Once the high density energy storage device 18 and the low density energy storage device 20 reach their maximum, the high density energy storage device 18 and the low density energy storage device 20 will no longer be able to act as power buffers for the DC bus 28. To avoid this scenario and ensure that the high density energy storage device 18 and the low density energy storage device 20 are available to act as power buffers, the high density energy storage device 18 and the low density energy storage device 20 are discharged regularly. For example, each of the high density energy storage device 18 and the low density energy storage device 20 is discharged at determined intervals or in response to its SOC being greater than a determined threshold value. In one embodiment, each of the high density energy storage device 18 and the low density energy storage device 20 is discharged to the DC bus 28 in order to power the load 30. In one embodiment, each of the high density energy storage device 18 and the low density energy storage device 20 is discharged to the resistive load bank 16 in case, for example, the total amount of power on the DC bus 28 is above a determined threshold value.

In one embodiment, energy storages connected to the DC bus 28 (*e.g.,* the high density energy storage device 18, the low density energy storage device 20, and any other energy storage devices connected to the DC bus 28) are discharged based on the average SOC of the energy storage devices. For example, the controller 22 monitors the SOC of the energy storage devices, determines the average SOC of the energy storage devices, and commands the energy storage devices to discharge a determined amount of power in response to the average SOC being greater than a determined maximum threshold value. The discharging of the energy storage devices are continued until the average SOC reaches a determined minimum threshold value.

In one embodiment, the energy storage devices are discharged to meet a discharge threshold value (DCH_TH2). The controller 22 also monitors the current power on the DC bus 28 (P_DCBUS), and controls the discharge of the energy storage devices to ensure that the power on the DC bus 28 does not fall below a DC bus threshold value (MINDCH_TH1).

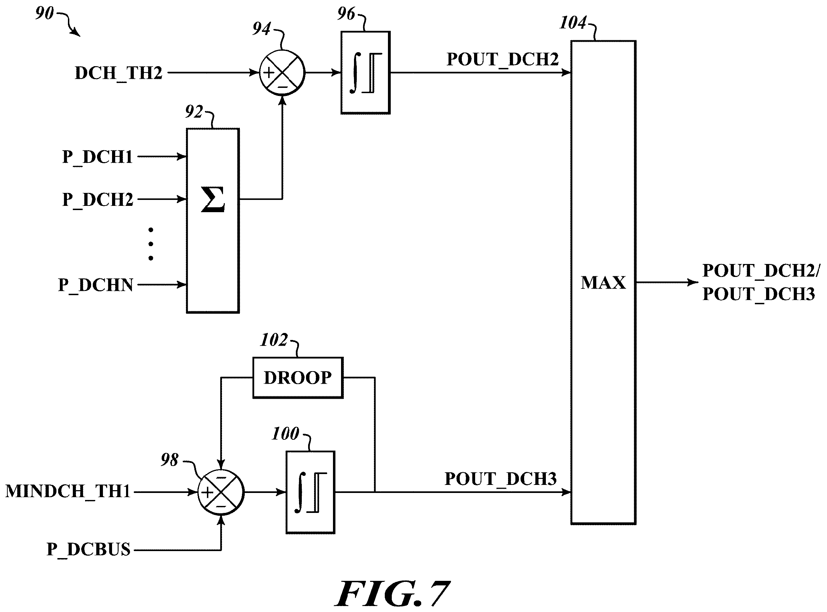

Figure 7 shows a system and method 90 of managing discharging of energy storage devices (e.g., the high density energy storage device 18, the low density energy storage device 20, and any other energy storage devices connected to the DC bus 28) according to an embodiment disclosed herein. In Figure 7, the controller 22 utilizes proportional integration control to discharge the energy storage devices, and Droop power control for sharing the load 30 between the fuel cell power systems 12 in parallel.

In block 92, the controller 22 determines the sum of the power output from the energy storage devices to the DC bus 28 (P_DCH1, P_DCH2 ... P_DCHN).

In block 94, the controller 22 determines a difference between (1) the discharge threshold value (DCH_TH2) and (2) the sum determined in block 92.

In block 96, the controller 22 determines an integral value of the difference determined in block 94 over a determined amount of time. The integral value represents the accumulation of the difference over the determined amount of time. The integral value determined in block 96 is a first candidate output power for discharging the energy storage devices (POUT_DCH2).

In block 98, the controller 22 determines a difference between (1) the DC bus threshold value (MINDCH_TH1) and (2) the current power level on the DC bus 28 (P_DCBUS) and the droop (*e.g*., voltage droop), if any, applied to the fuel cell power systems 12 (DROOP) (MINDCH_TH1 - P_DCBUS - DROOP).

In block 100, the controller 22 determines an integral value of the difference determined in block 98 over a determined amount of time. The integral value represents the accumulation of the difference over the determined amount of time. The integral value determined in block 100 is a second candidate output power for discharging the energy storages (POUT_DCH3).

In block 102, the controller 22 adjusts the value of the droop applied to the fuel cell power systems 12 (DROOP) based on the integral value determined in block 102. The adjusted droop is then used in a subsequent execution of block 98.

In block 104, the controller 22 selects the maximum of (1) the first candidate output power for discharging the energy storage devices (POUT_DCH2) determined in block 96 and (2) the second candidate output power for discharging the energy storage devices (POUT_DCH3) determined in block 100. Stated differently, the controller 22 selects the output power out of the first candidate output power (POUT_DCH2) and the second candidate output power (POUT_DCH3), that has the largest value. The selected output power is then output from the energy storage devices to the DC bus 28 in order to discharge the energy storage devices. In one embodiment, the selected output power is divided amongst the energy storage devices such that the each energy storage device is discharged by an equal portion of the selected output power. In one embodiment, the selected output power is proportionally divided amongst the energy storage devices based on the energy storage devices' current SOC such that the each energy storage device is discharged by a proportional amount of the selected output power.

As discussed above, the discharging of the energy storage devices is continued until the average SOC reaches a determined minimum threshold value.

In one embodiment, the discharging of the energy storage devices is interrupted in cases where there is a demand for charging the energy storage devices. For example, discharging of the high density energy storage device 18 is stopped and is instead charged in response to the method 48 of Figure 3 determining that the high density energy storage device 18 should be charged. Similarly, discharging of the low density energy storage device 20 is stopped and is instead charged in response to the method 66 of Figure 4 determining that the low density energy storage device 20 should be charged. Discharging of the energy storage devices again resumes once the charging is completed, and is continued until the average SOC reaches the determined minimum threshold value.

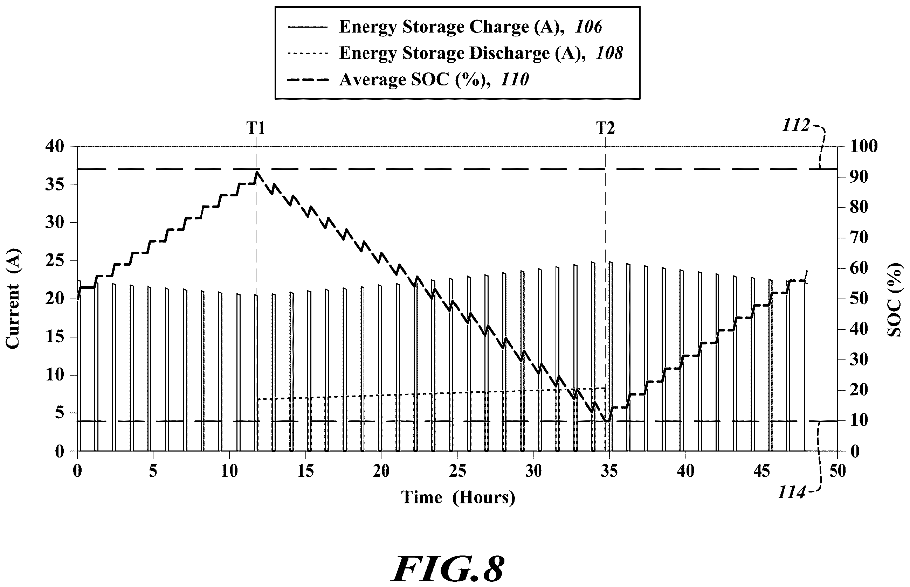

This approach provides hysteresis control of the SOC of the energy storages connected to the DC bus 28, with charging of the energy storage devices taking priority over the discharging of the energy storage devices. The energy storage devices undergo major charges and discharge cycles with a plurality of minor cycles therebetween. For example, Figure 8 shows signals for the high density energy storage device 18 according to an embodiment disclosed herein.

A signal 106 indicates electrical current input to the high density energy storage device 18, a signal 108 indicates electrical current output from the high density energy storage device 18, and a signal 110 indicates the average SOC of energy storage devices connected to the DC bus 28. The left vertical axis is an amplitude axis in amps, the right vertical axis is an amplitude axis in SOC percentage, and the horizontal axis is a time axis in hours. Although the signals 106 and 108 are for the high density energy storage device 18, the signals of the low density energy storage device 20 or another type of energy storage device will have similar characteristics.

The signal 106, which indicates electrical current input to the high density energy storage device 18, increases each time the high density energy storage device 18 is charged. For example, each time the power consumption of the load 30 decreases, the high density energy storage device 18 is charged. Conversely, the signal 106 decreases each time charging of the high density energy storage device 18 is stopped. For example, each time the power consumption of the load 30 increases, charging of the high density energy storage device 18 is stopped.

As the high density energy storage device 18 is repeatedly charged during this process, as well as other energy storage devices connected to the DC bus 28, the signal 110, which indicates the average SOC, incrementally increases.

At time T1, the signal 110 reaches a determined maximum threshold value 112, and the controller 22 commands the high density energy storage device 18 and the other energy storage devices to begin discharging. As a result, the signal 110 begins decreasing. In addition, the signal 108, which indicates electrical current output from the high density energy storage device 18, increases.

A time T2, the signal 110 reaches a determined minimum threshold value 114, and the controller 22 commands the high density energy storage device 18 and the other energy storage devices to stop discharging. As a result, the signal 110 begins increasing again. In addition, the signal 108, which indicates electrical current output from the high density energy storage device 18, decreases.

Between times T1 and T2, the discharging of the high density energy storage device 18 is interrupted in response to demands for charging the high density energy storage device 18. The charging interruptions correspond to increases in the signal 106, which indicates electrical current input to the high density energy storage device 18. As a result, the signal 110 decreases from time T1 to T2 with minor increases corresponding to the charging interruptions.

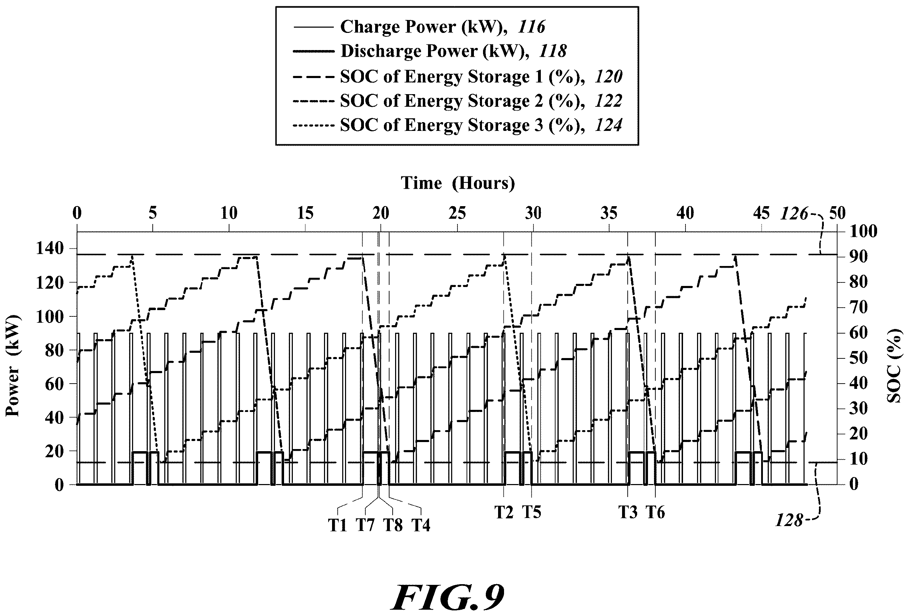

In one embodiment, in contrast to the embodiment shown in Figure 8, the discharging of the energy storage devices is not interrupted in cases where there is a demand for charging the energy storage devices. Instead, the SOC of the energy storage devices is maintained in a phase shifted manner such that one or more of the energy storage devices are allowed to reach the determined maximum threshold value (or the determined minimum threshold value) at a given time. This approach minimizes the amount of switching between charging and discharging during discharge, and improves the useful life of the energy storage devices. For example, Figure 9 shows signals for three high density energy storage devices according to an embodiment disclosed herein.

A signal 116 indicates the charge power from the DC bus 28 to the three high density energy storage devices (energy storage device 1, energy storage device 2, energy storage device 3); a signal 118 indicates the discharge power from the three high density energy storage devices to the DC bus 28; and signals 120, 122, 124 respectively indicate the SOC of the three high density energy storage devices. The left vertical axis is an amplitude axis in kilowatts, the right vertical axis is an amplitude axis in SOC percentage, and the horizontal axis is a time axis in hours. Although the signals 116, 118, 120, 122, 124 are for high density energy storage devices 18, signals for low density energy storage devices 20 or other types of energy storage devices will have similar characteristics.

The signal 116, which indicates the charge power from the DC bus 28 to energy storage device 1, energy storage device 2, and energy storage device 3, increases each time energy storage device 1, energy storage device 2, and energy storage device 3 are charged. For example, energy storage device 1, energy storage device 2, and energy storage device 3 are charged at determined intervals or in response to the power consumption of the load 30 decreasing. Conversely, the signal 116 decreases each time charging of energy storage device 1, energy storage device 2, and energy storage device 3 is stopped. For example, charging of energy storage device 1, energy storage device 2, and energy storage device 3 is stopped at determined intervals or in response to the power consumption of the load 30 increasing.

As the power of energy storage device 1, energy storage device 2, and energy storage device 3 is repeatedly charged during this process, the signals 120, 122, 124, which indicate the SOC of energy storage device 1, energy storage device 2, and energy storage device 3, incrementally increase.

The power of energy storage device 1, energy storage device 2, and energy storage device 3 eventually reaches a determined maximum threshold value 126, and the controller 22 commands energy storage device 1, energy storage device 2, and energy storage device 3 to begin discharging. As a result, the signals 120, 122, 124 begin decreasing. In addition, the signal 118, which indicates the discharge power from energy storage device 1, energy storage device 2, and energy storage device 3 to the DC bus 28, increases.

The power of energy storage device 1, energy storage device 2, and energy storage device 3 eventually reaches a determined minimum threshold value 128, and the controller 22 commands energy storage device 1, energy storage device 2, and energy storage device 3 to stop discharging. As a result, the signals 120, 122, 124 begin increasing again. In addition, the signal 118, which indicates the discharge power from energy storage device 1, energy storage device 2, and energy storage device 3 to the DC bus 28, decreases.

As can be seen in Figure 9, the charging and discharging of each of energy storage device 1, energy storage device 2, and energy storage device 3 is similar to the charging and discharging of the high density energy storage device 18 discussed with respect to Figure 8. However, the charging and discharging of energy storage device 1, energy storage device 2, and energy storage device 3 are staggered in time. Namely, energy storage device 1, energy storage device 2, and energy storage device 3 are set to begin charging in successive time intervals (*e.g*., energy storage device 2 begins charging after energy storage device 1 has started charging, and energy storage device 3 begins charging after energy storage device 2 has started charging). Similarly, energy storage device 1, energy storage device 2, and energy storage device 3 are set to begin discharging in successive time intervals (*e*.*g*., energy storage device 2 begins discharging after energy storage device 1 has started discharging, and energy storage device 3 begins discharging after energy storage device 2 has started discharging). As a result, each of energy storage device 1, energy storage device 2, and energy storage device 3 reach the determined maximum threshold value 126 at different times (*e.g*., times T1, T2, T3, respectively), and, thus, are discharged at different times. Similarly, each of energy storage device 1, energy storage device 2, and energy storage device 3 reach the determined minimum threshold value 128 at different times (*e.g*., times T4,' T5, T6, respectively), and, thus, are charged at different times.

In addition, once an energy storage device (*e.g*., energy storage device 1, energy storage device 2, or energy storage device 3) is commanded to discharge, the energy storage device is no longer available for charging even if there is a demand for charging. Instead, the energy storage device pauses its charging while another energy storage device is charged, and resumes discharging once the charging is completed. For example, there is a charge demand at time T7, and the discharging of energy storage device 1 is suspended while energy storage device 2 and energy storage device 3 are charged. Discharging of energy storage device 1 is subsequently resumed at time T8 after charging of energy storage device 2 and energy storage device 3 is completed. As the discharging of energy storage device 1, energy storage device 2, and energy storage device 3 is not interrupted in response to charging demands, the decrease of signals 120, 122, 124 do not have minor increases like the signal 110 in Figure 8.

In some cases, there may be a surplus of power on the DC bus 28 and energy storage devices (*e.g*., the high density energy storage device 18 and the low density energy storage device 20) connected to the DC bus 28 are unavailable to store the surplus power on the DC bus 28. For example, the energy storage devices may all be fully charged or be unavailable due to maintenance or a scheduled shut down. In these cases, as discussed above, the surplus power on the DC bus 28 may be transferred to the resistive load bank 16 and the external grid 24. As such, reduction of the output power of the fuel cell power systems 12 or shutdown of the fuel cell power systems 12 may be avoided.

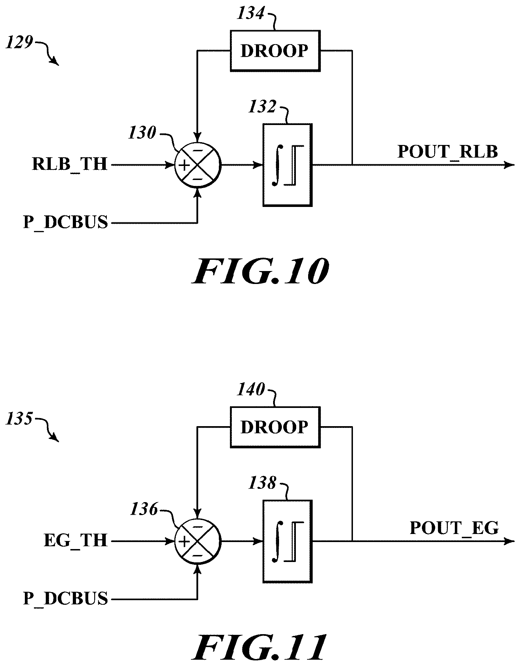

Figure 10 shows a system and method 129 of managing discharging of the DC bus 28 to the resistive load bank 16 according to an embodiment disclosed herein. In Figure 10, the controller 22 utilizes proportional integration control to discharge the DC bus 28 to the resistive load bank 16, and Droop power control for sharing the load 30 between the fuel cell power systems 12 in parallel.

In block 130, the controller 22 determines a difference between (1) a resistive load bank threshold value (RLB_TH) and (2) the current power level on the DC bus 28 (P_DCBUS) and the droop (*e.g*., voltage droop), if any, applied to the fuel cell power systems 12 (DROOP) (RLB_TH - P_DCBUS - DROOP).

In block 132, the controller 22 determines an integral value of the difference determined in block 130 over a determined amount of time. The integral value represents the accumulation of the difference over the determined amount of time

In block 134, the controller 22 adjusts the value of the droop applied to the fuel cell power systems 12 (DROOP) based on the integral value determined in block 132. The adjusted droop is then used in a subsequent execution of block 130.

The integral value determined in block 132 is set as the output power for discharging the DC bus 28 (POUT_RLB), and output from the DC bus 28 to the resistive load bank 16. As a result, the power on the DC bus 28 is decreased.

In case the resistive load bank 16 utilizes pulse width modulation to control the amount of power dissipated to the resistive load bank 16, the duty cycle of the power output to the resistive load bank 16 is adjusted based on the integral value determined in block 132. For example, the duty cycle of the resistive load bank 16 is proportionally set according to the value of the integral value determined in block 132.

Figure 11 shows a system and method 135 of managing discharging of the DC bus 28 to the external grid 24 according to an embodiment disclosed herein. In Figure 11, the external grid 24 is electrically coupled to the DC bus 28, and the controller 22 utilizes proportional integration control to discharge the DC bus 28 to the external grid 24, and Droop power control for sharing the load 30 between the fuel cell power systems 12 in parallel.

In block 136, the controller 22 determines a difference between (1) an external grid threshold value (EG_TH) and (2) the current power level on the DC bus 28 (P_DCBUS) and the droop (e.g., voltage droop), if any, applied to the fuel cell power systems 12 (DROOP) (RLB_TH - P_DCBUS - DROOP).

In block 138, the controller 22 determines an integral value of the difference determined in block 136 over a determined amount of time. The integral value represents the accumulation of the difference over the determined amount of time.

In block 140, the controller 22 adjusts the value of the droop applied to the fuel cell power systems 12 (DROOP) based on the integral value determined in block 138. The adjusted droop is then used in a subsequent execution of block 136.

The integral value determined in block 138 is set as the output power for discharging the DC bus 28 (POUT _EG), and output from the DC bus 28 to the external grid 24. As a result, the power on the DC bus 28 is decreased. In one embodiment, a DC to AC converter of the bi-directional inverter 44 converts the power from the DC bus 28 to AC, and supplies the AC to the external grid 24.

The various embodiments disclosed herein provide a system architecture and control methods that employ fuel cell-based power generation as the primary energy source. The system utilizes, for example, one or more different types of energy storage devices to supplement power output by the fuel cells, as well as store any excess power generated by the fuel cells. As a result of the various supporting modules and technologies, swings in the power output by the fuel cells are minimized and the function life of the of the fuel cells in the fuel cell systems may be extended.

A system may be summarized as including: a first power bus; a plurality of fuel cell power systems electrically coupled to the first power bus, the plurality of fuel cell power systems configured to output first power signals to the first power bus; a plurality of energy storage devices electrically coupled to the first power bus, the plurality of energy storage devices including a first energy storage device configured to: output a second power signal to the first power bus; and receive a third power signal from the first power bus; and a controller configured to: determine a power level on the first power bus; determine a first power output based on the power level on the first power bus; determine a first sum of power output from the first power bus to the plurality of energy storage devices; determine a second power output based on the first sum of power output; and set a power output from the first power bus to the first energy storage device based on the first power output and the second power output.

The system may further include: a plurality of inverters electrically coupled to the first power bus; and a second power bus electrically coupled to the plurality of inverters, the first power bus being a direct current (DC) power bus, the second power bus being an alternating current (AC) power bus, the plurality of inverters configured to convert DC power from the first power bus to AC power for the second power bus, the AC bus configured to provide the AC power to a load.

The load includes processing systems for artificial intelligence model training.

The system may further include: a resistive load bank electrically coupled to the first power bus, the resistive load bank configured to dissipate power on the first power bus, the controller configured to set a power output from the first power bus to the resistive load bank based on the power level on the first power bus.

The plurality of energy storages devices includes a second energy storage device having a lower storage capacity than the first energy storage device and faster charging and discharging times than the first energy storage device.

The controller is configured to: set a power output from the first power bus to the second energy storage device based on the power level on the first power bus; and set a power input from the second energy storage device to the first power bus based on the power level on the first power bus.

The controller is configured to: set the power output from the first power bus to the first energy storage device to the first power output in case the first power output is less than the second power output; and set the power output from the first power bus to the first energy storage device to the second power output in case the second power output is less than the first power output.

The controller is configured to set a power output from the first energy storage device to the first power bus based on an average of state of charges (SOCs) of the plurality of energy storage devices.

The controller is configured to: determine a second sum of power output from the plurality of energy storage devices to the first power bus; determine a third power output based on the second sum of power output; determine a fourth power output based on the power level on the first power bus; and set a power output from the plurality of energy storage devices to the first power bus based on the third power output and the fourth power output.

The controller is configured to: set the power output from the plurality of energy storage devices to the first power bus to the third power output in case the third power output is greater than the fourth power output; and set the power output from the plurality of energy storage devices to the first power bus to the fourth power output in case the fourth power output is greater than the third power output.

The controller is configured to: set a power output from the plurality of energy storage devices to the first power bus; and stop the power output from the plurality of energy storage devices to the first power bus in response to the power output from the first power bus to the first energy storage device being set.

The controller is configured to: charge the plurality of energy storage devices from the first power bus in successive time intervals; and discharge the plurality of energy storage devices to first power bus in successive time intervals.

The first power bus is electrically coupled to an external grid, and the controller may be configured to set a power output from the first power bus to the external grid based on the power level of the first power bus.

Each of the plurality of fuel cell power systems includes a plurality of power modules, each of the plurality of power modules including a hot box.

Each hot box includes one or more fuel cell stacks.

The one or more fuel cell stacks include solid oxide fuel cells interleaved with conductive interconnects.

A system may be summarized as including: a power bus; a plurality of fuel cell power systems electrically coupled to the power bus; a plurality of energy storage devices electrically coupled to the power bus; and a controller configured to set a power output from the power bus to a first energy storage device of the plurality of energy storage devices based on a power level on the power bus and power output from the power bus to the plurality of energy storage devices.

The controller is configured to set a power output from the first energy storage device to the power bus based on an average of state of charges (SOCs) of the plurality of energy storage devices.

A method may be summarized as including: determining, by a controller, a power level on a power bus that is electrically coupled to a plurality of fuel cell power systems and a plurality of energy storage devices; determining, by the controller, a first power output based on the power level on the power bus; determining, by the controller, a first sum of power output from the power bus to the plurality of energy storage devices; determining, by the controller, a second power output based on the first sum of power output; and setting, by the controller, a power output from the power bus to a first energy storage device of the plurality of energy storage devices based on the first power output and the second power output.

The method may further include: setting, by the controller, a power output from the first energy storage device to the power bus based on an average of state of charges (SOCs) of the plurality of energy storage devices.

The various embodiments described above can be combined to provide further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled.

## Claims

1. A system, comprising:
a first power bus;
a plurality of fuel cell power systems electrically coupled to the first power bus, the plurality of fuel cell power systems configured to output first power signals to the first power bus;
a plurality of energy storage devices electrically coupled to the first power bus, the plurality of energy storage devices including a first energy storage device configured to:
output a second power signal to the first power bus; and
receive a third power signal from the first power bus; and
a controller configured to:
determine a power level on the first power bus;
determine a first power output based on the power level on the first power bus;
determine a first sum of power output from the first power bus to the plurality of energy storage devices;
determine a second power output based on the first sum of power output; and
set a power output from the first power bus to the first energy storage device based on the first power output and the second power output.

2. The system of claim 1, further comprising:
a plurality of inverters electrically coupled to the first power bus; and
a second power bus electrically coupled to the plurality of inverters, the first power bus being a direct current (DC) power bus, the second power bus being an alternating current (AC) power bus, the plurality of inverters configured to convert DC power from the first power bus to AC power for the second power bus, the AC bus configured to provide the AC power to a load, optionally wherein the load includes processing systems for artificial intelligence model training.

3. The system of claim 1 or 2, further comprising:
a resistive load bank electrically coupled to the first power bus, the resistive load bank configured to dissipate power on the first power bus, the controller configured to set a power output from the first power bus to the resistive load bank based on the power level on the first power bus.

4. The system of claim 1, 2 or 3, wherein the plurality of energy storage devices includes a second energy storage device having a lower storage capacity than the first energy storage device and faster charging and discharging times than the first energy storage device, optionally wherein the controller is configured to:
set a power output from the first power bus to the second energy storage device based on the power level on the first power bus; and
set a power input from the second energy storage device to the first power bus based on the power level on the first power bus.

5. The system of any preceding claim wherein the controller is configured to:
set the power output from the first power bus to the first energy storage device to the first power output in case the first power output is less than the second power output; and
set the power output from the first power bus to the first energy storage device to the second power output in case the second power output is less than the first power output.

6. The system of any preceding claim wherein the controller is configured to set a power output from the first energy storage device to the first power bus based on an average of state of charges (SOCs) of the plurality of energy storage devices.

7. The system of any preceding claim wherein the controller is configured to:
determine a second sum of power output from the plurality of energy storage devices to the first power bus;
determine a third power output based on the second sum of power output;
determine a fourth power output based on the power level on the first power bus; and
set a power output from the plurality of energy storage devices to the first power bus based on the third power output and the fourth power output, optionally wherein the controller is configured to:
set the power output from the plurality of energy storage devices to the first power bus to the third power output in case the third power output is greater than the fourth power output; and
set the power output from the plurality of energy storage devices to the first power bus to the fourth power output in case the fourth power output is greater than the third power output.

8. The system of any preceding claim wherein the controller is configured to:
set a power output from the plurality of energy storage devices to the first power bus; and
stop the power output from the plurality of energy storage devices to the first power bus in response to the power output from the first power bus to the first energy storage device being set.

9. The system of any preceding claim wherein the controller is configured to:
charge the plurality of energy storage devices from the first power bus in successive time intervals; and
discharge the plurality of energy storage devices to first power bus in successive time intervals.

10. The system of any preceding claim wherein the first power bus is electrically coupled to an external grid, and the controller is configured to set a power output from the first power bus to the external grid based on the power level of the first power bus.

11. The system of any preceding claim wherein each of the plurality of fuel cell power systems includes a plurality of power modules, each of the plurality of power modules including a hot box, optionally wherein each hot box includes one or more fuel cell stacks, further optionally wherein the one or more fuel cell stacks include solid oxide fuel cells interleaved with conductive interconnects.

12. A system, comprising:
a power bus;
a plurality of fuel cell power systems electrically coupled to the power bus;
a plurality of energy storage devices electrically coupled to the power bus; and
a controller configured to set a power output from the power bus to a first energy storage device of the plurality of energy storage devices based on a power level on the power bus and power output from the power bus to the plurality of energy storage devices.

13. The system of claim 12 wherein the controller is configured to set a power output from the first energy storage device to the power bus based on an average of state of charges (SOCs) of the plurality of energy storage devices.

14. A method, comprising:
determining, by a controller, a power level on a power bus that is electrically coupled to a plurality of fuel cell power systems and a plurality of energy storage devices;
determining, by the controller, a first power output based on the power level on the power bus;
determining, by the controller, a first sum of power output from the power bus to the plurality of energy storage devices;
determining, by the controller, a second power output based on the first sum of power output;
and
setting, by the controller, a power output from the power bus to a first energy storage device of the plurality of energy storage devices based on the first power output and the second power output.

15. The method of claim 14, further comprising:
setting, by the controller, a power output from the first energy storage device to the power bus based on an average of state of charges (SOCs) of the plurality of energy storage devices.
